Europäisches Patentamt

European Patent Office

Office européen des brevets

(11) Publication number: **0 407 941 A1**

# EUROPEAN PATENT APPLICATION

(21) Application number: 90113096.3

(22) Date of filing: 09.07.90

(51) Int. Cl.5: **C30B 23/02, C30B 29/22**

(30) Priority: 10.07.89 JP 178228/89

(43) Date of publication of application:
**16.01.91 Bulletin 91/03**

(84) Designated Contracting States:
**DE FR GB NL**

(71) Applicant: **NEC CORPORATION**
**7-1, Shiba 5-chome Minato-ku**
**Tokyo 108-01(JP)**

Applicant: **SEISAN KAIHATSU KAGAKU**
**KENKYUSHO**
**15, Shimogamo Morimoto-cho**
**Sakyo-ku Kyoto-shi Kyoto-fu(JP)**

(72) Inventor: **Takada, Toshio**
**1, Nishisenouchi-cho, Kitashirakawa**
**Sakyo-ku, Kyoto-shi, Kyoto-fu(JP)**
Inventor: **Terashima, Takahito**
**63, Higashiogura-cho, Kitashirakawa**
**Sakyo-ku, Kyoto-shi, Kyoto-fu(JP)**
Inventor: **Bando, Yoshichika**
**8-15, Koyo-cho, Ohtsu-shi**
**Siga-ken(JP)**

(74) Representative: **Vossius & Partnerner**
**Siebertstrasse 4 P.O. Box 86 07 67**
**D-8000 München 86(DE)**

(54) Thin film of Ln2-xcexcuo4-y single crystal and process for producing the same.

(57) A thin film of a single crystal of an oxide having a composition formula of
$Ln_{2-x}Ce_xCuO_{4-y}$
wherein Ln is at least one rare earth element selected from the group consisting of Pr, Nd, and Sm and x is a number of 0.14 to 0.18, wherein the (001) plane of the single crystal is parallel with the film surface, which thin film exhibits superconductivity without post-treatment. The film is produced by simultaneously evaporating Ln, Ce, and Cu from discrete evaporation sources while supplying oxygen gas close to the substrate surface.

Fig. 1

EP 0 407 941 A1

## THIN FILM OF LN$_{2-x}$CE$_x$CUO$_{4-y}$ SINGLE CRYSTAL AND PROCESS FOR PRODUCING THE SAME

The present invention relates to a thin film of Ln-Ce-Cu-O base single crystal and a process for producing the same. In particular, the present invention relates to a thin film of a single crystal of an oxide having a composition formula of

$Ln_{2-x}Ce_xCuO_{4-y}$

wherein Ln is at least one rare earth element selected from the group consisting of Pr, Nd and Sm, which exhibits superconductivity, and a process for producing such thin film.

Since J. G. Bednorz and K. A. Mueller discovered a La base oxide superconductor, vigorous researches have been made for discovering novel materials which have higher superconductive critical temperature $T_c$, and Y base, Bi base and Tl base oxides which exhibit superconductivity at a temperature higher than the boiling point of liquid nitrogen (77 K) have been found.

In 1989, Tokura et al found a $Ln_{2-x}Ce_xCuO_{4-y}$ base material which has different properties from the already known high temperature superconductors (cf. Nature 337 (1989) 345). In the high temperature superconductive oxide comprising copper, carriers are holes, while in the $Ln_{2-x}Ce_xCuO_{4-y}$ base material, they are electrons. To achieve the superconductive characteristics in the $Ln_{2-x}Ce_xCuO_{4-y}$ base material, reduction of the material in vacuo is necessary. This characteristic is far different from that of the already known superconductive oxides which require sufficient oxidation. In particular, when the high temperature superconductor is used in electronic devices, it should be used in a thin film form. Since the thin film of the superconductor is prepared by a vacuum process, it is very difficult to make a thin film from the already known oxide superconductors in vacuo since the oxidation in vacuo is almost impossible technically.

In case of the $Ln_{2-x}Ce_xCuO_{4-y}$ base material, once the crystal of the material is grown, its superconductivity is not deteriorated if the crystal is post-treated in vacuo. This property of the $Ln_{2-x}Ce_xCuO_{4-y}$ base material is very advantageous in the practical applications.

It is also found that the coherent length of the $Ln_{2-x}Ce_xCuO_{4-y}$ base material in a direction in parallel with the (001) plane is measured to be 70 Å with its single crystal, ·which is longer than the coherent length of other oxide superconductors. This is advantageous in the production of a Josephson device.

Since the $Ln_{2-x}Ce_xCuO_{4-y}$ base material is a newly found material, there are a few papers on the production of a thin film of this material (cf. S. Hayashi, H. Adachi, K. Setsune, T. Hirano and K. Wasa, Japanese Journal of Applied Physics 28 (1989) L962; S. Saitoh, M. Hiratani and K. Miyauchi, Japanese Journal of Applied Physics 28 (1989) L975). Since the thin film of the $Ln_{2-x}Ce_xCuO_{4-y}$ base material was produced by sputuring, the film as a whole was not substantially a single crystal, and it was made superconductive through several steps of thermal treatment.

One object of the present invention is to provide a thin film of a single crystal of $Ln_{2-x}Ce_xCuO_{4-y}$ base material which exhibits superconductivity.

Another object of the present invention is to provide a process for producing such thin film.

According to the first aspect of the present invention, there is provided a thin film of a single crystal of an oxide having a composition formula of

$Ln_{2-x}Ce_xCuO_{4-y}$

wherein Ln is at least one rare earth element selected from the group consisting of pr, Nd, and Sm and x is a number of 0.14 to 0.18, the (001) plane of which single crystal is parallel with the film surface.

According to the second aspect of the present invention, there is provide a process for producing a thin film of a single crystal of an oxide having a composition formula:

$Ln_{2-x}Ce_xCuO_{4-y}$

wherein Ln and x are the same as defined above, which process comprises simultaneously evaporating Ln, Ce and Cu in an atomic ratio of about 2-x:x:1 from discrete evaporation sources of Ln, Ce and Cu to deposit them on a substrate in a vacuum vessel while supplying an oxygen gas from a distance close to the substrate to form an oxygen-containing atmosphere having a relatively high pressure at the substrate.

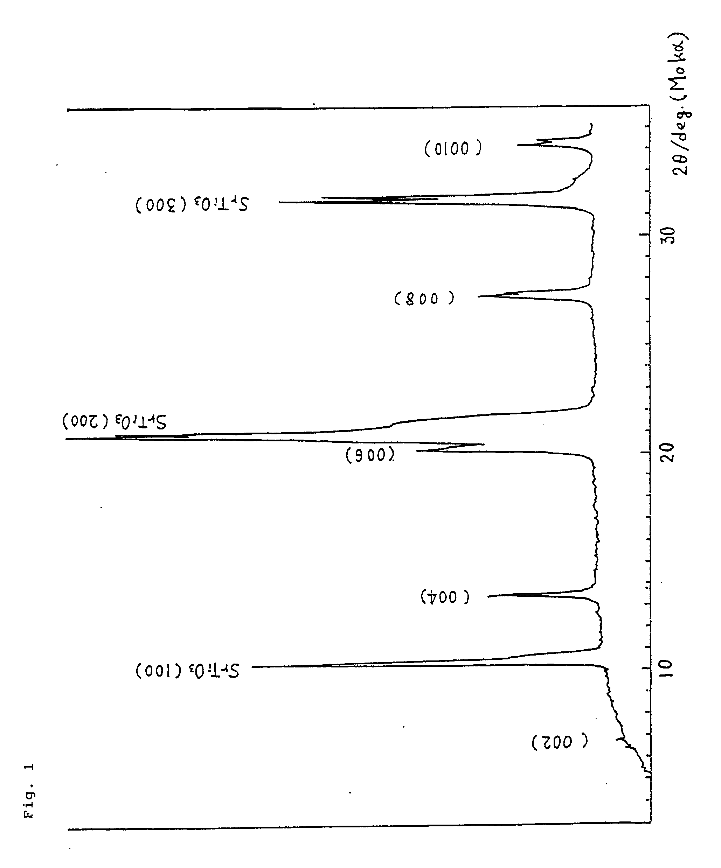

The invention will be described in detail in connection with the drawings in which Fig. 1 shows the X-ray diffraction pattern of the $Nd_{2-x}Ce_xCuO_{4-y}$ thin film formed in Example 1,

Fig. 2 is the reflection high energy electron diffraction photograph of the $Ln_{2-x}Ce_xCuO_{4-y}$ thin film formed in Example 1 and

Fig. 3 is a graph showing a relationship between resistivity and absolute temperature of the $Nd_{2-x}Ce_xCuO_{4-y}$ thin film formed in Example 2.

In the process of the present invention, the substrate has the (001) plane in its surface on which the single crystal $Ln_{2-x}Ce_xCuO_{4-y}$ is grown. As the substrate material, $SrTiO_3$ is preferably used, although other substrate materials may be used.

In the process of the present invention, the vacuum vessel is firstly evacuated to high vacuum of, for example, about $10^{-6}$ Torr. and then a small amount of the oxygen gas is continuously supplied towards the substrate from a distance close to the substrate to increase the pressure of oxygen at the substrate to $10^{-2}$ to $10^{-1}$ Torr while an internal gas in the vessel is continuously exhausted from a suitable part of the vessel to keep background pressure at $10^{-5}$ to $10^{-3}$ Torr. The reason why the upper limit of the background pressure is selected to be $10^{-3}$ Torr is that the metal elements in the evaporation sources are constantly evaporated without deterioration. The lower limit of $10^{-5}$ Torr is the minimum gas pressure for generating the plasma. If the plasma is not utilized, this lower limit is not technically important.

The reason why the oxygen gas pressure is increased only near the substrate is that Cu is not oxidized to $Cu^{+2}$ if the oxygen gas pressure is lower than $10^{-3}$ Torr.

The plasma may be generated by placing a high frequency coil between the evaporation sources and the substrate and oscillating it between the coil and the vessel wall at high frequency. While the plasma generation is preferred since reaction activities of the evaporated metals are increased and a single crystal with better quality can be obtained, it may have some drawbacks that the plasma attacks the desired material which is being formed if the plasma energy is too high. Therefore, an electric power for generating the plasma is preferably in a range from 50 to 500 W, preferably around 100 W.

Ln and Ce are evaporated by the electron beam, and Cu is evaporated by electric resistance heating. During evaporation of the metals by the above described evaporation means, the atomic ratio of Ln, Ce and Cu is adjusted to about 2-x:x:1 by adjusting the electric power according to the results of preliminary experiments. Namely, in the preliminary experiments, how much metal Ln, Ce or Cu is evaporated and how much the corresponding oxide is formed by the specific electric power applied to each evaporation source per unit time are measured by a film thickness measuring device installed in the vacuum evaporation vessel near the substrate for each metal. Thereby, a relationship between an evaporation rate of each metal and the applied electric power is established and the the electric power to be applied to each evaporation source during formation of the thin film of $Ln_2$-$_xCe_xCuO_{4-y}$ single crystal is determined.

The temperature of the substrate is can be easily determined and preferably 750 to 800°C.

The thin film of the $Ln_{2-x}Ce_xCuO_{4-y}$ single crystal of the present invention can be controlled by adjusting the conditions such as deposition time. Preferably, the thickness is at least 1000Å. The maximum thickness of the thin film is not critical, but preferably does not exceed 10,000 Å from a practical view point.

In comparison with the sputtering method, the process of the present invention can produce reproducibly the desired material since it can be carried out while preventing contamination with impurities under easily controlled operating conditions.

The single crystal thin film of the present invention can exhibit superconductivity without post-treatment after the deposition of the thin film. Therefore, on this thin film, various other thin films can be successively formed, and the single crystal thin film of the present invention can be advantageously used for the production of electronic devices.

The present invention will be illustrated by following Examples.

Example 1

A vacuum vessel having a diameter of 1000 mm and a height of 1200 mm was evacuated to $10^{-6}$ by an oil diffusion pump.

As a substrate, a piece of $SrTiO_3$ single crystal was used with the (001) plane forming a substrate surface (10 mm x 10 mm). After placing the substrate in the vacuum vessel, it was heated to 800°C and kept at this temperature with a heater.

From a nozzle for supplying the oxygen gas provided near an edge of the substrate, the oxygen gas was directly blown onto the substrate, whereby the gas pressure was increased to $10^{-2}$ to $10^{-1}$ Torr. only near the substrate, while the pressure near the evaporation sources which were placed apart from the substrate was increased only to $10^{-4}$ Torr.

Metals Nd, Ce and Cu were evaporated from independent evaporation sources at such evaporation rates that the atomic ratio of Nd:Ce:Cu was 1.85:0.15:1 on the substrate. For example, Nd, Ce and Cu were evaporated at a rate of 2 Å /sec., 0.3 Å/sec. and 0.5 Å/sec., respectively in terms of grow rates of the corresponding oxides.

Between the substrate and the evaporation sources, a high-frequency (13.56 MHz) coil was placed, and high frequency was applied at 100 W so as to generate oxygen plasma, which activated the evaporated metals and accelerated the reactions on the substrate.

Under the above conditions, the metal oxides were deposited on the substrate to form a thin film having a thickness of 1000 Å. After the formation of the thin film, the supply of the oxygen gas towards the substrate was stopped, and the thin film on the substrate was cooled to room temperature.

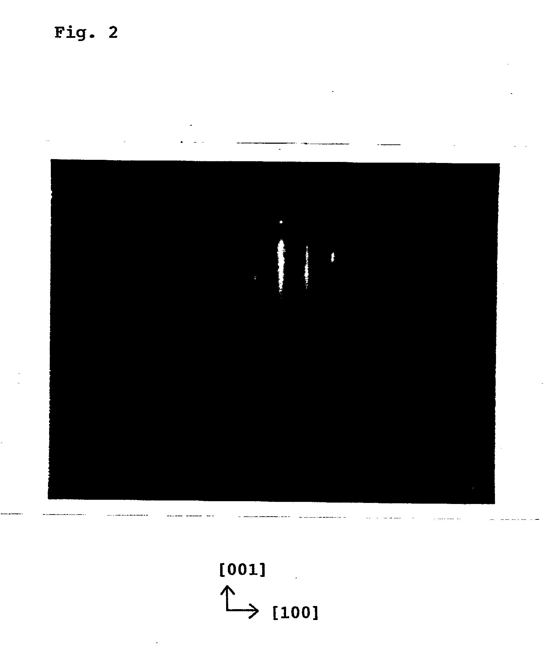

The X-ray diffraction pattern of the formed thin film is shown in Fig. 1, and the reflecting high energy electron diffraction (RHEED) photograph of the thin film is shown in Fig. 2.

Example 2

In the same manner as in Example 1, a thin film of $Nd_{2-x}Ce_xCuO_{4-y}$ single crystal having a thickness of 1200 Å was formed.

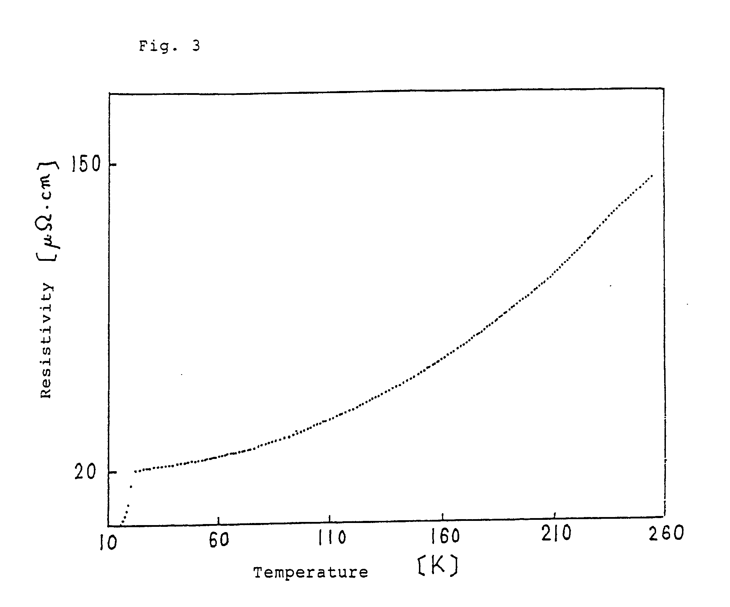

A relationship between resistivity and absolute temperature was measured. The result is shown in Fig. 3. With no post-treatment, the formed thin film exhibited the metallic resistance change versus temperature and its resistance became 0 (zero) at 15 K.

## Claims

1. A thin film of a single crystal of an oxide having a composition formula of
$Ln_{2-x}Ce_xCuO_{4-y}$
wherein Ln is at least one rare earth element selected from the group consisting of Pr, Nd, and Sm and x is a number of 0.14 to 0.18, the (001) plane of which single crystal is parallel with the film surface.

2. The thin film according to claim 1, wherein said oxide has a composition formula: $Nd_{2-x}Ce_xCuO_{4-y}$ wherein x is the same as defined above.

3. A process for producing a thin film of a single crystal of an oxide having a composition formula of
$Ln_{2-x}Ce_xCuO_{4-y}$
wherein Ln is at least one rare earth element selected from the group consisting of Pr, Nd, and Sm and x is a number of 0.14 to 0.18, wherein the (001) plane of the single crystal is parallel with the film surface, which process comprises simultaneously evaporating Ln, Ce and Cu in an atomic ratio of about 2-x:x:1 from discrete evaporation sources of Ln, Ce and Cu to deposit them on a substrate in a vacuum vessel while supplying an oxygen gas from a distance close to the substrate to form an oxygen-containing atmosphere having a relatively high pressure at the substrate.

4. The process according to claim 3, wherein plasma is generated between the evaporation sources and the substrate.

Fig. 1

EP 90 113096.3

EP 0 407 941 A1

Fig. 2

[001]

↑
└→ [100]

Fig. 3

# DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | APPLIED PHYSICS LETTERS, vol. 56, no. 7, 12th February 1990, pages 677-679, New York, US; T. TERASHIMA et al.: "In situ growth of superconducting Nd-Ce-Cu-O thin films" * Page 677 * | 1-4 | C 30 B 23/02 C 30 B 29/22 |
| Y | JOURNAL OF VACUUM SCIENCE & TECHNOLOGY B, vol. 7, no. 2, March/April 1989, pages 319-323, New York, US; J.N. ECKSTEIN et al.: "Epitaxial growth of high-temperature superconducting thin films" * Figure 1; page 319 * | 3,4 | |
| Y | APPLIED PHYSICS LETTERS, vol. 54, no. 26, 26th June 1989, pages 2713-2715, New York, US; H. ADACHI et al.: "Superconducting (Nd,Ce)2CuO4 thin films grown by rf magnetron sputtering" * Page 2713 * | 3,4 | |
| A | EP-A-0 294 285   (SUMITOMO LTD) | | |
| A | JAPANESE JOURNAL OF APPLIED PHYSICS/PART 2: LETTERS, vol. 27, no. 1, January 1988, pages L91-L93, Tokyo, JP; T. TERASHIMA et al.: "Single-crystal YBa2Cu3O7-x thin films by activated reactive evaporation" | | |

TECHNICAL FIELDS SEARCHED (Int. Cl.5)

C 30 B
H 01 L

The present search report has been drawn up for all claims

| Place of search | Date of completion of search | Examiner |
|---|---|---|
| The Hague | 29 October 90 | COOK S.D. |

CATEGORY OF CITED DOCUMENTS

X : particularly relevant if taken alone
Y : particularly relevant if combined with another document of the same category
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document